Europäisches Patentamt

European Patent Office

Office européen des brevets

(19)

(11) Publication number: **0 117 211 B1**

# EUROPEAN PATENT SPECIFICATION

(12)

(45) Date of publication of patent specification: 17.04.91

(51) Int. Cl.⁵: **H01L 23/48**, H01L 21/48, H01L 23/04

(21) Application number: 84400335.0

(22) Date of filing: 17.02.84

(54) Method for fabricating a package for an integrated circuit.

(30) Priority: 18.02.83 US 468029

(43) Date of publication of application:
29.08.84 Bulletin 84/35

(45) Publication of the grant of the patent:
17.04.91 Bulletin 91/16

(84) Designated Contracting States:
DE FR GB IT NL

(56) References cited:
EP-A- 0 069 505
EP-A- 0 071 423

SOLID STATE TECHNOLOGY, vol. 18, no. 5,
May 1975, pages 42-44, New York, US; J.F.
BURGESS et al.:"Hybrid packages by the di-
rect bonded copper process"

IBM TECHNICAL DISCLOSURE BULLETIN, vol.
25, no. 7A, December 1982, pages 3512-3513,
New York, US; N.G. JONES: "Module with
force-fit pinning of ceramic substrate"

IBM TECHNICAL DISCLOSURE BULLETIN, vol.
21, no. 8, January 1979, page 3120, New York,

US; G.E. ANDERSON: "Ceramic substrate
with recessed pins"

NACHRICHTENTECHNIK ELEKTRONIK, vol.
31, no. 8, 1981, pages 335-338, East-Berlin,
DD; E. HEYMANN: "Neue Montagetech-
nologien bei der Fertigung von Hybridschalt-
kreisen"

(73) Proprietor: FAIRCHILD SEMICONDUCTOR
CORPORATION
10400 Ridgeview Court P.O. Box 1500
Cupertino, California 95014(US)

(72) Inventor: Phy, William S.
25616 Moody Road
Los Altos Hills California 94022(US)

(74) Representative: Sparing Röhl Henseler Paten-
tanwälte European Patent Attorneys
Rethelstrasse 123
W-4000 Düsseldorf 1(DE)

## Description

This invention relates to packages or enclosures for integrated circuits, and in particular to a method for fabricating a package for an integrated circuit which enables the use of high density tape bonding for forming electrical connections between the circuit and the package.

In the manufacture of integrated circuits, silicon wafers containing many separate integrated circuits are fabricated and divided into individual circuits, each known as a die. Each die is individually packaged, using any one of a variety of well-known techniques. During packaging, electrically conductive leads are attached to the die, also by known techniques, such as wire bonding or tape automated bonding.

Tape bonding is a technique for interconnecting an integrated circuit to leads fabricated on a continuous carrier film. The tape is usually a laminate of copper and a plastic insulator, and the leads are etched in the copper while on the plastic carrier using conventional techniques. The film is perforated along one or both edges with sprocket holes used for advancement and registration.

Each pattern of leads, referred to as a frame, includes a central opening through the carrier film. The inner ends of the leads overhang the central opening and may be bonded using thermocompression, ultrasonic, eutectic or reflow solder means, to an integrated circuit brought into close proximity with the opening. The outer portion of each lead is connected to a substrate onto which the die is also mounted. Typically, the outer portions of the leads may be formed downward or upward and bonded to the substrate or package after the inner ends of the leads are attached to the die and the die to the substrate.

As integrated circuits have become larger and more complex, it has become increasingly desirable to make large numbers of connections to the integrated circuit in a relatively small area. A major problem when applying high density tape bonding to such applications is the inherent lack of precision of the outer lead bonds in conventional substrates or packages, particularly ceramic ones. Because the bonding position of the tape is fixed, and determined by the position of the bonding pads on the integrated circuit to which the inner lead bonds must connect, adjustment of the outer lead bonds is not possible. In applications where ceramic packages have been used, shrinkage of the green ceramic during firing is predictable only to about ± 0.5% On a package containing a hundred and forty leads with 30.5 μm (12 mil) outer lead bond center-to-center spacing, this can create an undesirably large error of 10.7 μm (4.2 mil). Additionally, further position errors due to slippage of ceramic layers during lamination, refractory printing, or co-firing can increase the dimensional errors, further lowering yields.

The process of the present invention aims at a package exhibiting small position errors and high connection density.

The publication "Hybrid packages by the direct bonded copper process", Solid State Technology, Vol. 18, #5, May 1975 , pages 42 to 44 discloses a process to bond copper foil directly to ceramic substrates by a thermal treatment. The processing temperature of 1065 °C to 1083 °C results in forming a thin liquid skin around the foil, wetting both the foil and the ceramic. It is emphasized that there be substantially no diffusion. In contrast thereto, the present invention provides a processing temperature well below the melting temperature of copper or eutectic mixtures thereof; according to the invention, bonding occurs as a result of copper oxide diffusion into the ceramic.

Fig. 1 is a cross-sectional view of the preferred embodiment of this invention.

Fig. 2 is a top view of a cross-section taken through the structure shown in Fig. 1.

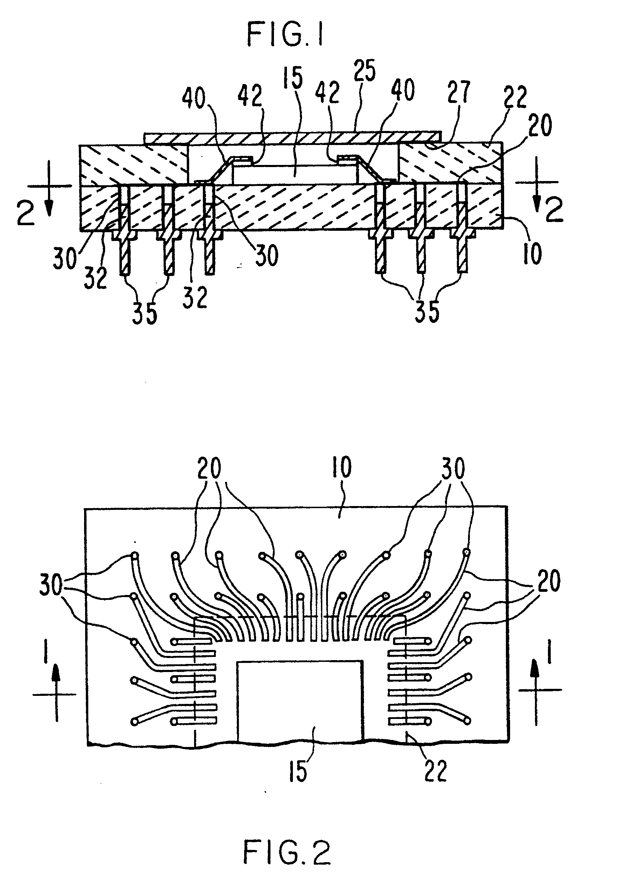

Fig. 1 is a cross-sectional view of one embodiment of the device enclosure of this invention suitable for high density tape bonding. The structure depicted in Fig. 1 includes a substrate 10, typically beryllium or aluminium oxide approximately 0,5 to 1,5 mm thick. The length and width of substrate 10 will be determined by the size of the integrated circuit 15, and the number and dimensions of the electrical connections to be made to circuit 15. On the upper surface of substrate 10 a relatively thin layer of metal foil, which has been formed into a desired pattern of electrical connections, is attached. A ceramic frame 22, typically fabricated from the same material as substrate 10, is attached to the upper surface of metal foil 20 as shown. A cover 25 is attached to frame 22 by sealing material 27. The combination of cover 25, frame 22, and substrate 10 completely encloses and hermetically seals integrated circuit 15. A series of openings 30 are formed to extend between the upper surface and lower surface of substrate 10. Each opening is internally coated with electrically conductive material such as copper. Pins 35 or other form of electrical connections are brazed in, or onto, openings 30 to electrically contact coating 32.

As shown in Fig. 2, electrically conductive pattern 20 forms an electrical connection between the coating 32 in openings 30, and a region disposed about the periphery of the integrated circuit. Tape bonding 40 (see Fig. 1) is used to provide electrical connections between bumps 42 on the integrated circuit 15 and the pattern 20. Thus, the package shown in Fig. 1 is adapted to be inserted into a socket, an array of openings in a printed circuit board, or other well-known external apparatus.

Fig. 2 shows a top view of the structure shown in Fig. 1 illustrating how openings 30 are typically formed in an array surrounding integrated circuit 15. Electrically conductive regions of pattern 20 extend between the plated openings 30 and the region disposed about the periphery of the integrated circuit 15 to enable fabrication of connections using tape automated bonding.

The structure shown in Figs. 1 and 2 may be fabricated in the following manner. Using well-known punching techniques openings 30 are made in ceramic substrate 10 and metallized to create plated openings. Substrates such as this may be commercially purchased from Kyocera, Ceramic Systems, or Spectrum Ceramics. Next, a relatively thin layer of copper metal foil, on the order of 12 to 25 μm thick, is placed on the upper surface of substrate 10 and heated to cause copper oxide to diffuse into the ceramic substrate and form a mechanically integral structure. In the preferred embodiment this process is achieved by heating the substrate in a nitrogen atmosphere to a temperature of about 920°C for 10 minutes. Typically the surface of the ceramic substrate 10 previously will have been cleaned by a chemical or thermal process. After diffusion the copper layer 20 will be electrically connected to the plating material 32 in each of openings 30.

Using conventional photolithographic processing, layer 20 is next defined into the desired pattern. In the preferred embodiment this is achieved by application of photoresist to the upper surface of layer 20, followed by exposure of the photoresist to an appropriate pattern through a mask, removal of the undesired photoresist, and removal, typically by etching in a well-known manner, of the underlying undesired portions of copper 20. Of course, the pattern into which layer 20 is defined is determined by the particular integrated circuit 15 and desired pattern of pins 35. The pattern of copper connections 20 illustrated in Fig. 2 is for the purpose of illustration only, and will be varied as determined by the configurations of circuit 15 and pins 35.

After formation of the pattern of leads 20, a ceramic frame 22 is attached to the upper surface of substrate 10 and pattern 20. In the preferred embodiment frame 22 comprises ceramic of the same type as substrate 10 and is 0,25 to 1 mm thick. As shown, frame 22 will typically have the same exterior dimensions as substrate 10. Frame 22 is attached to the upper surface of substrate 10 and leads 20 by heating the assembly to cause the copper pattern 20 to also diffuse into the surface of frame 22. In the preferred embodiment this process is carried out at a temperature of about 920°C for about 10 minutes in a nitrogen atmosphere. If necessary the frame 22 may be cleaned in a caustic solution prior to the heat treatment to improve the adherence of frame 22 to pattern 20. Alternately frame 22 may be attached by using a glass frit seal. Tin or gold is then plated onto the etched copper to improve the reliability of the electrical connections. Electrically conductive pins 35, tyically gold plated copper, are then brazed into or on to the metallized openings 30 in substrate 10. In the preferred embodiment, for high density applications, the pins are located on a 127 μm (50 mil) center-to-center matrix.

Next, using conventional integrated circuit tape automated bonding technology, the inner leads of the tape are connected to the circuit 15, for example, by using eutectic bonding or other known process. Circuit 15 is then attached to substrate 10, for example, using a solder pre-form or other low temperature process. Tape automated bonding is performed to electrically connect the outer leads to the electrically conductive pattern 20 on the surface cf circuit 15. Next, a solder pre-form or other low temperature material such as lead-tin, silver, gold-tin or gold 27 is used to seal lid 25 across the opening in frame 22, to thereby hermetically encapsulate circuit 15.

The structure and process of this invention are particularly advantageous because they permit forming a high resolution precision pattern 20 using well-known photolithographic techniques. Because the conducting layers are sandwiched between layers of dielectrical material they are protected from damage by external handling to assure higher reliability connections. The invention overcomes the problems of prior art copper/ceramic packaging by providing precise registration between the pattern 20 and the tape bonding 40. Furthermore, the invention reduces the electrical resistance of the pattern 20 by providing very compact signal routing. The invention is particularly suitable for high density gate arrays or logic devices, and subsystems. The invention allows precise control over the position of pattern 20 to enable accurate registration with tape bonding conductors 40.

## Claims

1. A method for fabricating a package for an integrated circuit including the steps:
   - attaching a copper layer to an upper surface of an insulating substrate (10) composed of a ceramic material,
   - heating the ceramic substrate over about ten minutes to a temperature of about 920°C causing diffusion of copper oxide into said substrate so as to bond said copper layer to said substrate,
- selectively removing undesired portions of said copper layer after heating of the substrate to thereby form a pattern of electrically conductive regions (20),
- attaching a frame (22) to the pattern leaving an inner region of the pattern exposed, and
- providing electrical connections (32, 35) between the pattern (20) and a lower surface of the substrate (10).

2. A method as in claim 1 wherein the step of attaching a frame (22) comprises diffusing the pattern (20) into the frame (22).

3. A method as in claim 1 or 2 wherein said removing step includes etching of said undesired portions.

4. A method as in one of claims 1 through 3 wherein said electrical connections are provided by coating the interior of openings (30) which extend from said upper to said lower surface with an electrically conductive material (32).

5. A method as in claim 4 wherein electrically conductive pins (35) are attached to said coatings (32).

**Revendications**

1. Procédé pour fabriquer un boîtier pour un circuit intégré comprenant les opérations consistant à :
   - fixer une couche de cuivre sur une surface supérieure d'un substrat isolant (10) composé d'un matériau céramique,
   - chauffer le substrat en céramique pendant environ 10 minutes à une température d'environ 900° C entraînant une diffusion d'oxyde de cuivre dans ledit substrat afin d'assembler ladite couche de cuivre audit substrat,
   - retirer sélectivement les parties non désirées de ladite couche de cuivre après le chauffage du substrat pour former ainsi un motif de régions électriquement conductrices (20),
   - fixer un cadre (22) au modèle à l'exception d'une première région et
   - fournir des premières connexions électriques (32, 35) entre le motif (20) et une surface inférieure du substrat (10).

2. Procédé selon la revendication 1, dans lequel l'opération consistant à fixer un cadre (22) comprend une diffusion du motif (20) dans le cadre (22).

3. Procédé selon la revendication 1 ou 2, dans lequel l'étape consistant à retirer comprend le gravage desdites portions non désirées.

4. Procédé selon l'une des revendications 1 à 3, dans lequel lesdites premières connexions électriques sont fournies en revêtant l'intérieur des ouvertures (30) qui s'étendent à partir de ladite surface supérieure à ladite surface inférieure avec un matériau électriquement conducteur (32).

5. Procédé selon la revendication 4, dans lequel des broches électriquement conductrices (35) sont fixées audits revêtements (32).

**Ansprüche**

1. Ein Verfahren für die Herstellung einer Packung für einen integrierten Schaltkreis umfassend die Schritte:
   - Anbringen einer Kupferschicht auf einer oberen Oberfläche eines isolierenden Substrats (10), bestehend aus einem Keramikmaterial,
   - Aufheizen des Keramiksubstrats über etwa zehn Minuten auf eine Temperatur von etwa 920° C unter Bewirken der Diffusion von Kupferoxid in das Substrat, um so die Kupferschicht an dem Substrat zum Anhaften zu bringen,
   - selektives Abtragen unerwünschter Abschnitte der Kupferschicht nach dem Aufheizen des Substrats, um auf diese Weise ein Muster elektrisch leitender Bereiche (20) zu schaffen,
   - Anbringen eines Rahmens (22) auf dem Muster mit Ausnahme eines ersten Bereichs, und
   - Herstellen erster elektrischer Verbindungen (32, 35) zwischen dem Muster (20) und einer unteren Oberfläche des Substrats (10).

2. Ein Verfahren nach Anspruch 1, bei dem der Schritt des Anbringens eines Rahmens (22) das Diffundieren des Musters (20) in den Rahmen (22) umfaßt.

3. Ein Verfahren nach Anspruch 1 oder 2, bei dem der Abtragschritt das Ätzen der unerwünschten Abschnitte umfaßt.

4. Ein Verfahren nach einem der Ansprüche 1 bis 3, bei dem die ersten elektrischen Verbindungen hergestellt werden durch Beschichten des Inneren von Öffnungen (30), die sich von der oberen zur unteren Oberfläche erstrecken mit einem elektrisch leitenden Material (32).

5. Ein Verfahren nach Anspruch 4, bei dem elektrisch leitende Stifte (35) an den Beschichtungen (32) angebracht sind.

## FIG.1

## FIG.2